# EUROPEAN PATENT SPECIFICATION

(11) **EP 0 658 933 B1**
(45) Date of publication and mention of the grant of the patent: **10.10.2001**
(21) Application number: 94309456.5
(22) Date of filing: 16.12.1994
(51) Int. Cl.: H01L 23/22, H01L 33/00, H01S 5/022

(54) **Method for manufacturing light-emitting semiconductor devices**
Herstellungsverfahren für lichtemittierenden Halbleitervorrichtungen
Méthode de fabrication de dispositifs semi-conducteurs photoémetteurs

(30) Priority: 16.12.1993 JP 31660693; 08.06.1994 JP 12610394
(43) Date of publication of application: 21.06.1995
(73) Proprietor: Sharp Kabushiki Kaisha, Osaka-shi, Osaka 545-8522 (JP)
(72) Inventor: Ishihara, Takehisa, Tenri-shi, Nara (JP)
(74) Representative: Suckling, Andrew Michael

(56) References cited:
- WO-A-91/03085
- WO-A-92/20096
- PATENT ABSTRACTS OF JAPAN vol. 008 no. 025 (E-225) ,2 February 1984 & JP-A-58 186980 (NIPPON DENKI KK) 1 November 1983,
- PATENT ABSTRACTS OF JAPAN vol. 013 no. 463 (E-833) ,19 October 1989 & JP-A-01 179483 (CANON INC) 17 July 1989,
- PATENT ABSTRACTS OF JAPAN vol. 005 no. 011 (E-042) ,23 January 1981 & JP-A-55 141770 (MATSUSHITA ELECTRIC IND CO LTD) 5 November 1980,
- PATENT ABSTRACTS OF JAPAN vol. 012, no. 063 (E-585) 25 February 1988 & JP-A-62 206 859 (MITSUBISHI ELECTRIC CORP) 11 September 1987
- PATENT ABSTRACTS OF JAPAN vol. 009, no. 225 (E-342) 11 September 1985 & JP-A-60 083 337 (OKI DENKI KOGYO KK) 11 May 1985
- PATENT ABSTRACTS OF JAPAN vol. 006, no. 230 (E-142) 16 November 1982 & JP-A-57 133 652 (HITACHI SEISAKUSHO KK) 18 August 1982

## Description

The present invention relates to a method of manufacturing semiconductor devices such as semiconductor laser devices and light emitting diode devices.

A semiconductor elements such as a semiconductor laser element (chip) is very small, easy to break, and highly affected by the ambient atmosphere, in particular by moisture. For the reasons, the semiconductor element is conventionally encapsulated in a package to use.

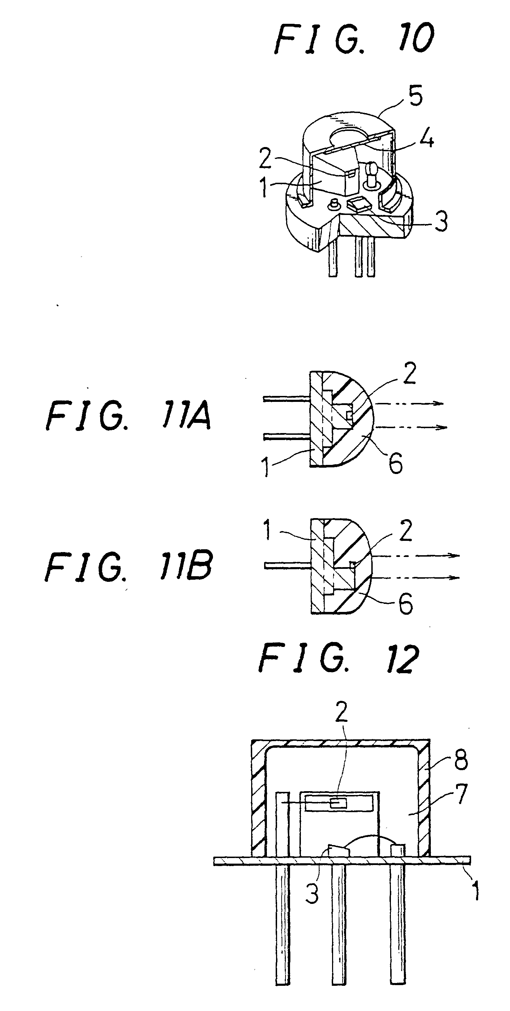

Fig. 10 shows an example of a hermetically sealed semiconductor laser device which is presently mass-produced.

The semiconductor laser device comprises a metal stem 1 integrated with a heat sink, on which a semiconductor laser element (chip) 2 and a light receiving element 3 for detecting an optical output from the semiconductor laser element 2, for example, a photodiode chip for monitoring, are mounted, which are electrically connected in their terminal by wire bonding, and is encapsulated in a manner such that a can package 5 mounting a flat glass 4 with a low melting point is seam-welded to the metal stem 1 in nitrogen ambience, and various functions such as moisture proofing and heat dissipation are maintained by filling nitrogen gas in the can package 5.

The semiconductor laser device hermetically sealed in the above-mentioned constitution is airtight, and the semiconductor laser element 2 is isolated from the outside air. Such semiconductor laser device, however, comprises a lot of parts and as well the steps for manufacturing such device are complicated, with the result that the device is disadvantageous from a view point of mass production and it is difficult to satisfy the requirements for cost reduction. Additionally, since the heat conductivity of nitrogen gas is low, there is no other way of dissipating the heat to the outside than through the metal stem 1, in order to release the heat radiated from the semiconductor laser device 2, and as a result a larger metal stem 1 is required, which leads to limitation of size reduction. Additionally, since a part of a laser beam passing through the flat glass 4 is reflected on the boundary with the nitrogen, disadvantageously the light availability is not so good. It is also a disadvantage that nitrogen is expensive.

In Japanese Unexamined Patent Publications JPA 60-63977 (1985) (hereinafter described as "prior art 1") and JPA 63-14489 (1988) (hereinafter described as "prior art 2") are disclosed semiconductor laser devices to solve the above problems. Figs. 11A, 11B are views showing the constitution of prior art 1, which are a cross-sectional view and a vertical-sectional view, respectively. Fig. 12 is a front sectional view showing the constitution of prior art 2.

In the semiconductor laser device of prior art 1, as shown in Figs. 11A, 11B, a semiconductor laser element 2 is mounted on a metal stem 1 having a high thermal conductivity, a transparent resin member 6 is formed which seals the semiconductor device 2, and the surface of the transparent resin member 6 is made to be curved. According to the constitution, the number of parts can be reduced, and the improvements regarding size reduction and mass-production are achieved as well as reduction of manufacturing cost.

In the semiconductor laser device of prior art 2, as shown in Fig. 12, the fundamental constitution is completely the same as that of prior art 1 as shown in Fig. 11 except that the semiconductor laser device 2 and light receiving element 3 which are held on the stem 1 are entirely sealed by a moisture adsorption material 7 having a high light transmissivity such as a transparent gel, which is coated with a transparent resin layer 8. According to the constitution, the mass productivity is enhanced by using the inexpensive moisture adsorption material 7 and transparent resin layer 8 without depressing the functions of the device such as moisture resistance and thermal conductivity and as a result inexpensive semiconductor laser devices are obtained.

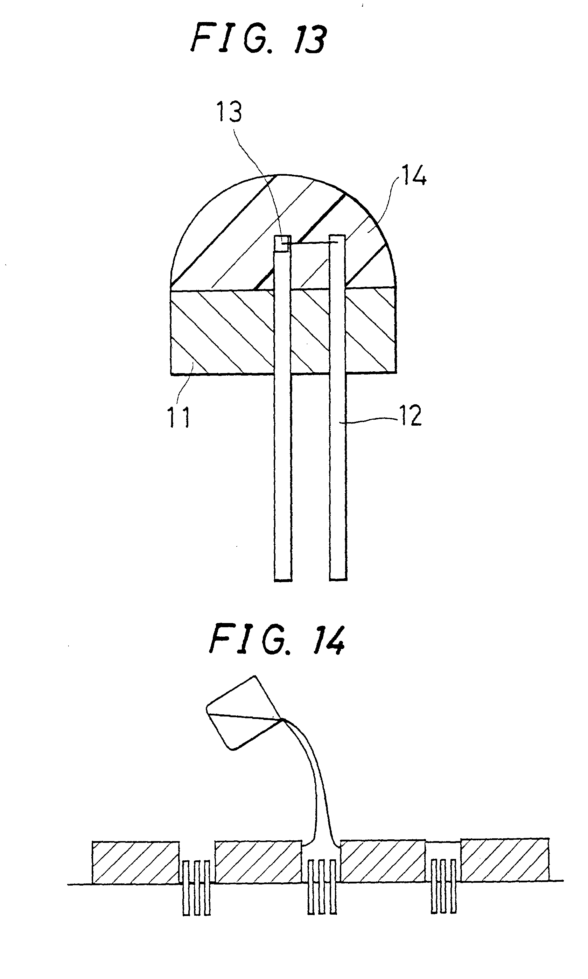

An embodiment of a conventional light emitting diode device sealed by a ceramic based resin is shown in Fig. 13.

The light emitting diode device is manufactured to have a such constitution that a light emitting diode element (chip) 13 is mounted on a lead frame 12 fixed by a ceramic base substrate 11, the light emitting diode element 13 is electrically connected to a terminal by wire bonding, and the light emitting diode element is encapsulated with a sealing material 14 such as a transparent epoxy resin.

The above light emitting diode device is manufactured by the casting method as shown in Fig. 14, the dipping method as shown in Fig. 15, and the dropping method as shown in Fig. 16.

Such a light emitting diode device, however, is difficult to meet the requirements for reducing the manufacturing cost because of the necessity of the ceramic base substrate 11.

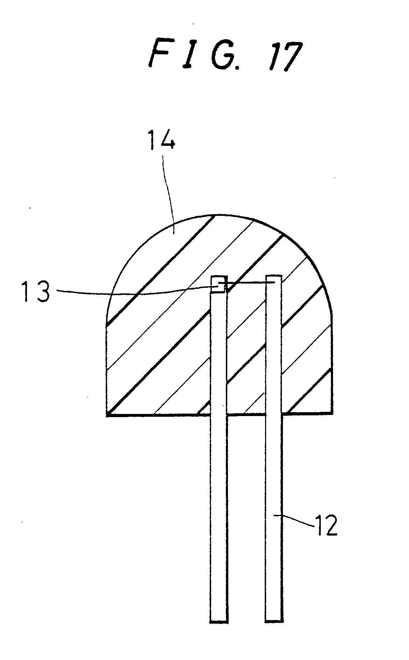

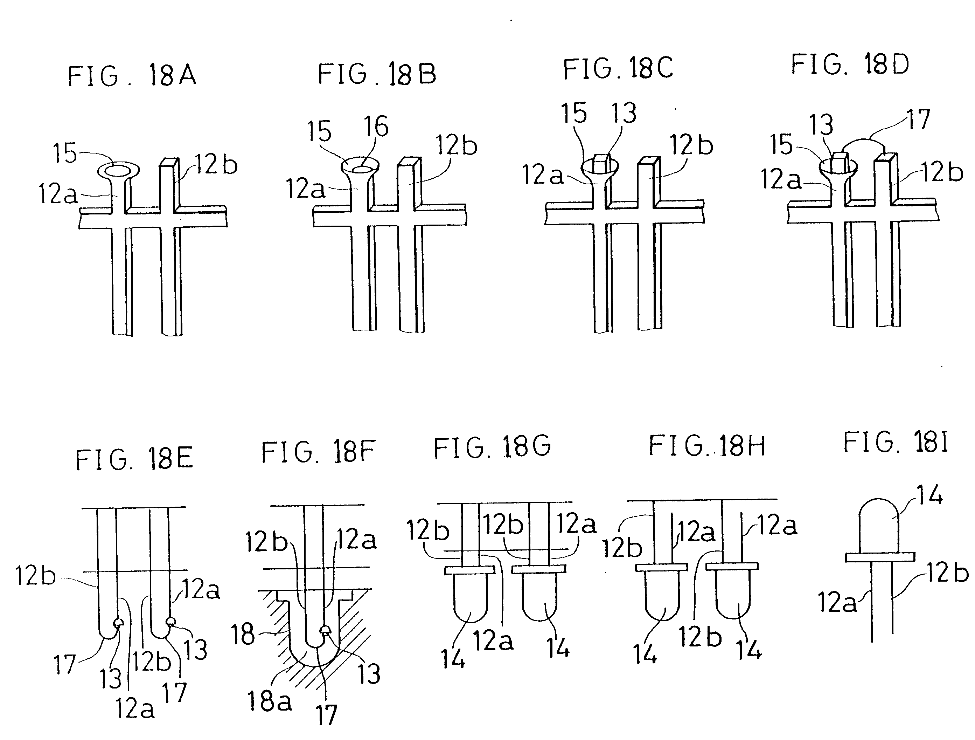

Accordingly, as shown in Fig. 17, light emitting diode devices without the ceramic base substrate 11 have been mass-produced. The method for manufacturing the light emitting diode device is explained along with Figs. 18A-18I.

The light emitting diode device is manufactured by the use of a couple of metal lead frames 12a and 12b integrated into one. As shown in Fig. 18A, a disk-type base 15 is provided at an end of the lead frame 12a. As shown in Fig. 18B, Ag paste 16 is applied to the base 15 and as shown in Fig. 18C, the light emitting diode element (chip) 13 is die-bonded. After the Ag paste 16 is cured, the light emitting diode element (chip) 13 and the lead frame 12b are electrically connected via a bonding wire 17 such as a copper wire.

The above steps are conducted for each couple of lead frames 12a, 12b. When the state shown in Fig. 18E is reached, the ends of the lead frames 12a, 12b are inserted into a concave portion 18a of the mold case 18, and then, as shown in Fig. 18F, the concave is filled with a transparent resin (not shown). After being cured, the resin filling the concave is taken out from the mold case 18, as shown in Fig. 18G, and the resin is cut into couples of lead frames 12a, 12b to fabricate light emitting diode devices as shown in Fig. 18I.

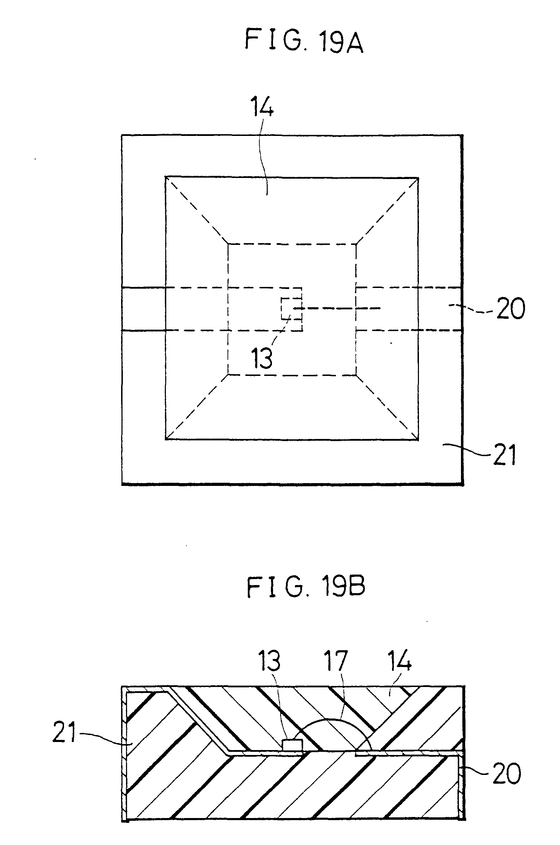

Recently, in order to further promote the size reduction, light emitting diode devices as parts mounted on a surface are mass-produced. In the devices, as shown in Fig. 19, a light emitting diode element 13 is mounted on a resin base substrate 21 including a surface electrode 20 made by metallizing or the like, the surface electrode 20 and the light emitting diode element 13 are electrically connected via a bonding wire or the like, and the light emitting diode device is hermetically encapsulated with a sealing material.

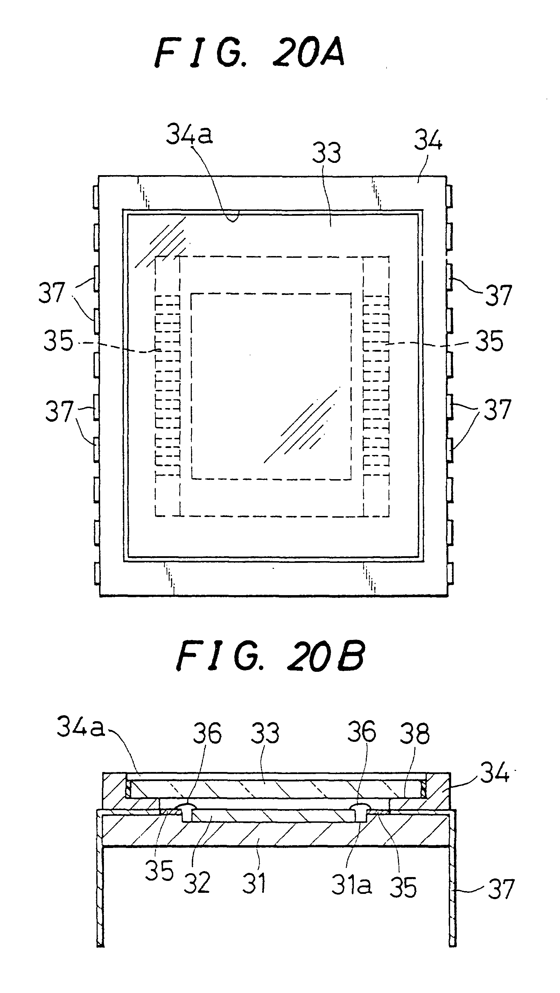

Fig. 20 shows an example of a conventional solid imager device in which a ceramic package is employed as a solid imager element such as a CCD.

The solid imager device comprises a metallized alumina substrate 31 provided with a concave 31a in the middle of the top face thereof, a solid imager element (CCD chip) 32 arranged in the concave 31a of the alumina substrate 31, a glass plate 33 covering the CCD chip 32, and an alumina cap 34 supporting the glass plate 33.

The CCD chip 32 is bonded to the alumina substrate 31, and electrically connected to the metallized electrode 35 provided on the surface of the alumina substrate 31 via a bonding wire 36. The metallized electrode 35 is electrically connected to the terminal 37.

The alumina cap 34 arranged on the alumina substrate 31 forms a kind of frame, which is provided with an opening in the middle portion thereof, and a flat glass plate 33 is supported in the opening 34a and sealed with a glass 38 having a low melting point. The glass plate 33 has an appropriate space from the surface of the CCD chip 32, and the space is filled with nitrogen. The CCD chip 32 is arranged in the nitrogen atmosphere to be isolated from the outside air.

However, since such a solid imager device is composed of a lot of parts and as well the manufacturing steps are complicated, the solid imager device is inferior in mass-production and it is very difficult to meet the requirements for reducing the manufacturing cost. Additionally, since a part of incident light passing through the flat glass 33 is reflected at the interface of the flat glass 33 and the nitrogen, the light availability of the solid imager device is disadvantageously not so high. Furthermore, since the incident light with a high intensity is reflected on the surface of the solid imager element 32, further reflected at the interface of the flat glass 33 and the nitrogen, and then enters into the solid imager element 32 again, disadvantageously a flare, which is a kind of false signal, or crosstalk is often caused. By those reasons, sealing the solid imager element 32 with a transparent resin is proposed (e.g., solid imager device under the trade name "LZ2314" made by Sharp K.K.).

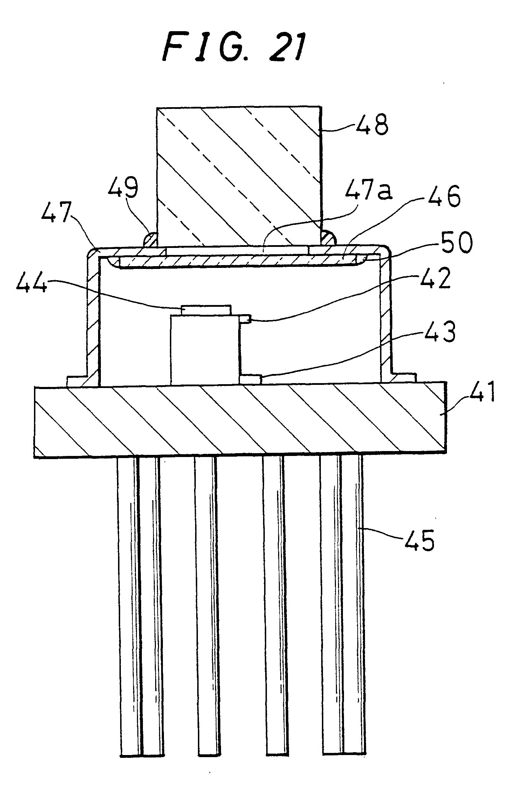

Fig. 21 shows a hermetically sealed semiconductor laser device for an optical pickup for an optical disk. The device is fabricated in a manner such that on a metal stem 41 are mounted a semiconductor laser element (chip) 42, a photodiode chip 43 for monitoring, and a photodiode chip 44 for detecting a signal, and they are electrically connected to terminals 45 by wire bonding or the like, a flat glass 46 mounted cap 47 is seam-welded in the ambience of nitrogen, and a hologram glass 48 is bonded to a window portion 47a of a flat glass 46 mounted cap 47 by the use of an adhesive material 49 such as an ultraviolet setting resin . The flat glass 46 of the cap 47 is stuck with the cap 47 without leaving any space therebetween.

However, it is difficult in such a semiconductor laser device to meet a demand for low costs because the semiconductor laser device is manufactured in relatively complicated steps and therefore the mass-productivity is not so high. Additionally, because of the low heat conductivity of nitrogen gas, in order to release the heat released from the semiconductor laser device 42, there is no other way than dissipating the heat to the outside through the metal stem 41, and as a result a larger metal stem 41 is required, which leads to limitation of size reduction. Since a part of the laser beam passing through the hologram glass 48 and flat glass 46 is reflected at the boundary with the nitrogen, disadvantageously the light availability is not so good. Similarly, since the light beam reflected on the hologram glass 48 and flat glass 46 is entered into the light receiving elements 43, 44, the semiconductor laser device has another disadvantage of decrease of S/N ratio. Furthermore, since an external objective lens or the like is needed in order to form a pickup for an optical disk by using the integrated-type part, and the manufacturing steps are complicated, the mass-productivity is not so high and as a result it is very difficult to meet a demand for low costs. In addition, the device has a limitation in reduction in size.

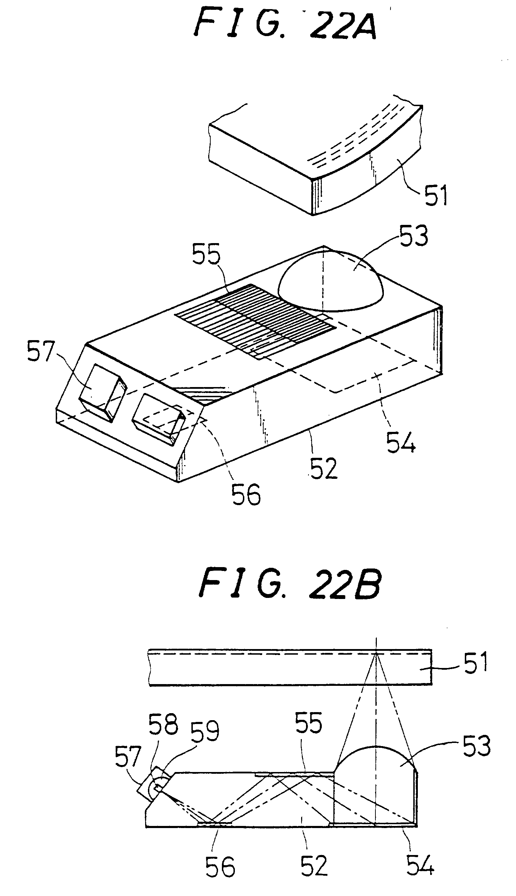

Hence, it is proposed in Unexamined Japanese Patent Publication JPA 5-12706 (1993) that as one body optical elements such as an objective lens and a hologram glass are formed out of a resin in order to reduce the manufacturing steps to a great extent, and the optical path is turned in order to reduce in size, as shown in Fig. 22. In Fig. 22, reference numeral 51 represents an optical disk, reference numeral 52 a transparent resin body, reference numeral 53 an objective lens, reference numeral 54 a hologram collimator lens, reference numeral 55 a hologram beam splitter, reference numeral 56 a three-beam diffraction grating or mirror, reference 57 a submount, reference numeral 58 a semiconductor laser element, and reference numeral 59 a shield material.

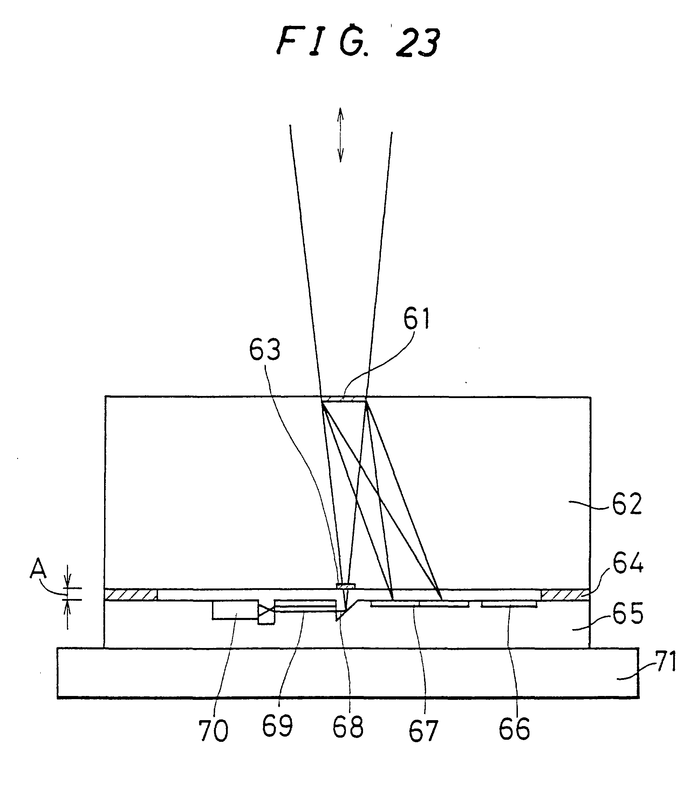

Additionally, it is proposed in Unexamined Japanese Patent Publication JPA 5-217199 (1993) that a light emitting element and a photo detector are formed on the same substrate in order to achieve cost and volume reduction, as shown in Fig. 23. In Fig. 23, reference numeral 61 represents a hologram beam splitter, reference numeral 62 a hologram glass, reference numeral 63 a three-beam diffraction grating, reference numeral 64 an adhesive material, reference numeral 65 a compound semiconductor substrate, reference numeral 66 an electronic processing circuit, reference numeral 67 a photo detector, reference numeral 68 a mirror, reference numeral 69 a semiconductor laser element, reference numeral 70 a photo detector for monitoring, and reference numeral 71 a mounting plate. In Fig. 23, a gap A between the hologram glass 62 and the compound semiconductor substrate 65 is provided only for the purpose of simplifying the description, and in practice the gap is hardly found.

However, it is difficult in a hermetically sealed semiconductor laser device as shown in Fig. 10 to meet a demand for low costs because the semiconductor laser device is manufactured in relatively complicated steps and therefore the mass-productivity is not so high. Additionally, because of the low heat conductivity of nitrogen gas,there is no other way than emitting the heat to the outside through the metal stem 41, in order to dissipate the heat released from the semiconductor laser device 42, and as a result a larger metal stem 41 is required, which leads to limitation of size reduction. Since a part of the laser beam passing through the hologram glass 48 and the flat glass 46 is reflected on the boundary with the nitrogen, disadvantageously the light availability is not so good.

There are found some disadvantages in a semiconductor laser device of the prior art 1 shown in Fig. 11 as follows:
1) In the case where the transparent resin body 6 is injection-molded, since foreign objects such as the semiconductor laser element 2 are arranged (by insertion molding), the refractive index of a sealing material (transparent resin) spatially fluctuates due to turbulence of the resin flow, and a desired wavefront aberration of an outgoing laser beam is not obtained. Additionally there is a possibility that the bonding wire is cut off by the injection pressure of the shielding material.
2) In the case where the transparent resin body is formed in a method such as cast-molding, it is possible to prevent the refractive index of the sealing material from spatially fluctuating on manufacturing. However, the heated semiconductor laser element 2 causes not only spatial temperature fluctuation and stress of a sealing material, but also spatial fluctuation of the refractive indexes thereof, which lead to an undesired wavefront aberration of an outgoing laser beam.
3) The heated semiconductor laser element 2 causes stress of the sealing material, which adversely affects the lifetime of the semiconductor laser element 2 or leads to separation of the boundary between the semiconductor laser element 2 and sealing material due to thermal stress with a result that the moisture resistance is decreased.

There are found some disadvantages in a semiconductor laser device of the prior art 2 shown in Fig. 12 as follows:
1) Since the water adsorbent 7 such as a transparent gel expands when it has adsorbed water, the expansion causes stress and spatial fluctuation of refractive indexes and as a result an undesired wavefront aberration is obtained.
2) When a moisture adsorbent 7 such as a transparent gel has a structure that water molecules are contained in a three-dimensional network structure of polymer, this is inferior in insulation property. By the reason, since, depending on the amount of water in the moisture adsorbent 7, an electric current leaks into the moisture adsorbent 7 when the resistance of a diode such as the semiconductor laser element 2 is high at the time of rising, there is a disadvantageous possibility that the diode is not turned on. Otherwise the responsivity of the diode is lowered.
3) The heated semiconductor laser element 2 causes not only spatial temperature fluctuation and stress of a filling material, but also spatial fluctuation of the refractive indexes thereof, which lead to an undesired wavefront aberration of an outgoing laser beam.

The wavefront aberration herein mentioned is a value to be controlled which is important in applications that a laser beam has to be concentrated up to the diffraction limitation ( e.g., an optical disk apparatus which is one of the main applications of semiconductor laser device), the wavefront aberration of a total optical system has to be less than or equal to Marechal's Criterion (0.07λrms).

Also in conventional light emitting diode devices as shown in Figs. 13, 17, 19, the same as semiconductor laser devices, as a result of a recent trend toward high outputs, the heated light emitting diode element 13 causes stress of the sealing material 14, which adversely affects the lifetime of the light emitting diode element 13 or leads to separation of the boundary between the light emitting diode element 13 and sealing material 14 due to thermal stress with a result that the moisture resistance is decreased.

When a solid imager device as shown in Fig. 20A, is sealed with a transparent resin in stead of nitrogen, with high recent speed application and increase in size (increase of imaging area) of a solid imager element, the heated solid imager element 32 causes stress of the sealing material, which adversely affects the lifetime of the solid imager element 32 or leads to separation of the boundary between the solid imager element 32 and sealing material due to thermal stress with a result that the moisture resistance is decreased.

Additionally, with increase in size of the solid imager device 32, contraction of the sealing material causes stress of the sealing material, which adversely affects the lifetime of the solid imager element 32 and decreases the flatness with a result that distortion is caused in a detected image.

Similarly to the hermetically sealed semiconductor laser device, integrated-type parts for a conventional pickup for an optical disk as shown in Fig. 21 comprise a great number of members and the manufacturing steps thereof are complicated. Accordingly, to meet a demand for low costs is difficult in such a integrated-type part and the mass-productivity is not so high. Additionally, because of the low heat conductivity of nitrogen gas, in order to dissipate the heat released from the semiconductor laser device 42, there is no other way than dissipating outside through the metal stem 41, and as a result a larger metal stem 41 is required, which limits reduction in size.

Since a part of the laser beam passing through the hologram glass 48 and the flat glass 46 is reflected on the boundary with the nitrogen, disadvantageously the light availability is not so good. Similarly, since the light beam reflected on the hologram glass 48 and flat glass 46 is entered into the light receiving elements 43, 44, the semiconductor laser device has another disadvantage of decrease of S/N ratio.

In other embodiment of an integrated-type device for an optical pickup for an optical disk as shown in Fig. 22, the heated semiconductor laser element 58 causes stress of the sealing material 59, which adversely affects the lifetime of the semiconductor laser element 58 or leads to separation of the boundary between the semiconductor laser element 58 and sealing material 59 due to thermal stress with a result that the moisture resistance is decreased. Furthermore, the heated semiconductor laser element 58 causes spatial temperature fluctuation and stress of the sealing material 59, leading to spatial fluctuation of refractive indexes thereof with a result that an undesired wavefront aberration is obtained.

In still other embodiment of an integrated-type device for an optical pickup for an optical disk as shown in Fig. 23, a compound semiconductor substrate 65 and an adhesive material 64 correspond to the stem 41 and the cap 46 of the hermetically sealed semiconductor laser device (Fig. 21), respectively. In this case, the adhesive material 64 is not applied to the gap of the compound semiconductor substrate 65 (at the mirror portion, laser portion, etc.), but has to be applied airtightly to the entire circumference of the gap without a break. This is difficult to do. Further in the case of the application of the adhesive material to the circumference of the gap, sealing is conducted by a resin. In this case, the heated semiconductor laser element 69 causes stress of the sealing material, which adversely affects the lifetime of the semiconductor laser element 69 or leads to separation of the boundary between the semiconductor laser element 69 and sealing material due to thermal stress with a result that the moisture resistance is decreased. Furthermore, the heated semiconductor laser element 69 causes spatial temperature fluctuation and stress of the sealing material, leading to spatial fluctuation of refractive indexes thereof with a result that an undesired wavefront aberration is obtained. Even when the positional relation between the hologram glass 62 and the compound semiconductor substrate 65 is adjusted before curing of the sealing material, the refractive index is changed before and after curing and disadvantageously the optical positional relation is possibly deviated.

To be brief, airtight sealing methods such as hermetical sealing and ceramic sealing have the following problems:
1) The methods have a limitation in cost reduction, because bonding with a glass with a low melting point or seam welding is carried out in order to prevent optical properties of an optical surface ( e.g., end face of a semiconductor laser element) from lowering due to oxidation or condensation of aluminum electrodes.
2) In the case of highly heated semiconductor elements, there is a limitation in size reduction because the amount of heat released from a package is needed to increase.
3) In sealing methods for optical semiconductor elements in which a glass window or optical element is mounted, there are disadvantages of decrease of S/N ratio and decrease of light availability at the boundary between the glass window or optical element and nitrogen or air due to light reflection.

Sealing methods with a resin have the following problems:
1) At the time of curing the resin, stress is caused in a sealing material, which adversely affects the lifetime of the semiconductor element.
2) At the time of curing the resin, stress is caused in a sealing material, which adversely affects the wavefront aberration of outgoing laser beams and decreases the flatness with a result that distortion is caused in a detected image.
3) The heated semiconductor element causes separation of the boundary between the semiconductor element and the sealing material due to thermal stress with a result that the moisture resistance is decreased.
4) The heated semiconductor element causes spatial temperature fluctuation and stress of the sealing material, leading to spatial fluctuation of refractive indexes thereof with a result that an undesired wavefront aberration is caused in entering/outgoing light.
5) Even when the positional relation among optical elements is adjusted before curing the resin, the refractive index is changed before and after curing and disadvantageously the optical positional relation is possibly deviated after curing.

JP-58 186 980, on which the preamble of claim 1 is based, discloses a semiconductor device which has a photo-semiconductor mounted in a metal cap. The cap is fusion-bonded to a stem, and has a terminal through which it is filled with an inert liquid. The terminal is sealed after the inert liquid has been introduced into the cap. An second opening is provided, in the upper face of the cap.

JP-A 1 179 483 discloses a laser chip which is mounted on a heat sink which, in turn, is mounted on a stem. A cap is mounted on the stem, and the interior of the cap is filled with an "inactive liquid". It appears that the cap has an opening through which the fluid is introduced into the cap.

WO 91/03085 shows a device which includes a light emitting semiconductor device mounted on a base. A cap is mounted on the substrate so as to cover the semiconductor device, and the cap is filled with a "cooling fluid". The cap is provided with a port, and this is used to fill the capsule with the cooling fluid.

WO 92/20096 discloses an arrangement for encasing a "functional device" - such as a semiconductor element, a sensor element or an electronic circuit. The device is placed in a casing, the casing is then filled with a liquid and/or gel material through openings in the casing, and the openings are subsequently sealed.

The present invention provides a method of manufacturing a semiconductor device of the type incorporating a sealing resin, the method comprising: arranging a semiconductor element on a substrate; mounting a cap on the substrate so as to cover the semiconductor element; and introducing a liquid material for sealing into the cap through an opening provided in the cap or the substrate;
the method being characterised in that it further comprises the step of closing the opening with an optical element after the step of introducing the liquid material (105, 304) into the cap; and that the semiconductor element is a light-emitting element.

In a preferred embodiment the semiconductor element is a semiconductor laser element (102, 102a).

In a preferred embodiment the liquid material is composed of a liquid resin.

The semiconductor element is an optical element such as a semiconductor laser element. In such an device, the opening provided in the cap is closed with an optical element which light is transmitted through.

According to the invention, the semiconductor element of the semiconductor device is protected against the outside air, and heat release of the semiconductor element is promoted. Additionally, since liquid resin is used, the temperature distribution and refractive index of the liquid resin are uniformed and the thermal stress is dispersed.

As described above, according to the invention, since the semiconductor element is sealed by the liquid resin, the heat of the heated semiconductor element can be effectively released by convection as well as heat conduction and radiation. As a result, size reduction of the device can be achieved.

Besides, since the viscosity of the liquid resin is about 1000 times that of the resin in gas, the liquid resin hardly leaks through the gap in the package. Accordingly the level of air tightness can be lowered, which leads to cost reduction.

Additionally, since the thermal stress caused in the fluid material is equally distributed without partially concentrating because of the features of the fluid material, it is prevented that the thermal stress adversely affects the lifetime of the semiconductor element or leads to separation of the boundary between the semiconductor element and sealing material due to thermal stress with a result that the moisture resistance is decreased.

### BRIEF DESCRIPTION OF THE DRAWINGS

Other and further objects, features, and advantages of the invention will be more explicit from the following detailed description taken with reference to the drawings wherein:

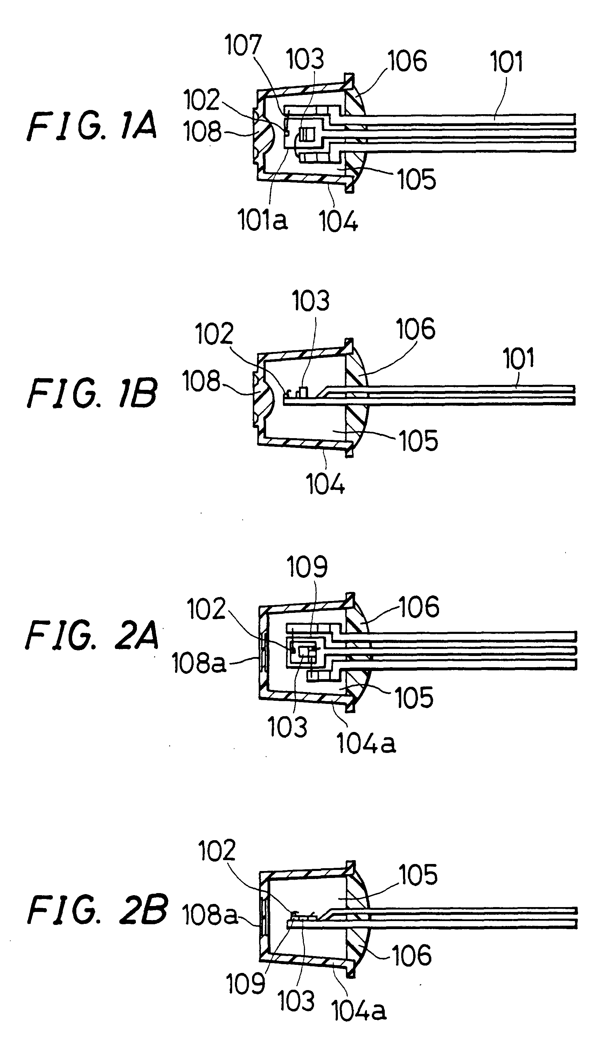

Figs. 1A, 1B are constitutional views of a first comparative example, particularly Fig. 1A a cross sectional view and Fig. 1B a longitudinal sectional view thereof;
Figs. 2A, 2B are constitutional views of a second comparative example, particularly Fig. 2A a cross sectional view and Fig. 2B a longitudinal sectional view thereof;

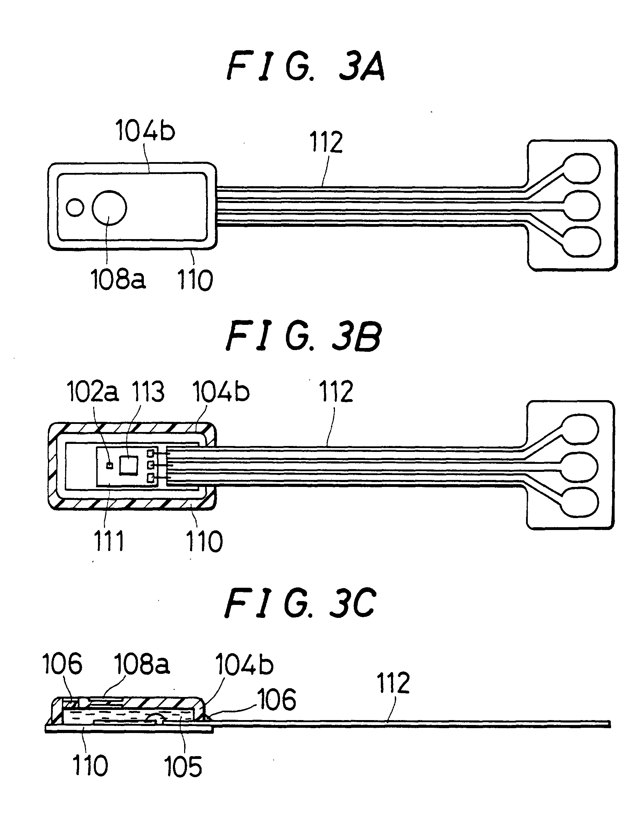

Figs. 3A-3C are constitutional views of a third comparative example, particularly Fig. 3A a plan view, Fig. 3B a cross sectional view and Fig. 3C a longitudinal sectional view thereof;

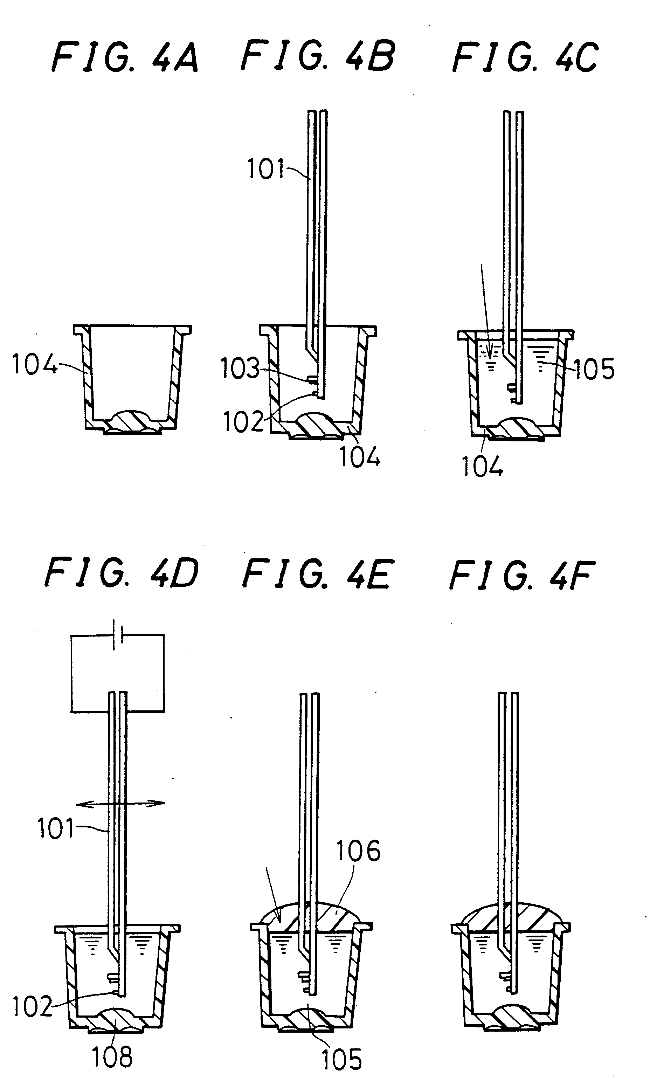

Figs. 4A-4F are views showing manufacturing steps of the semiconductor laser device of Fig. 1A;

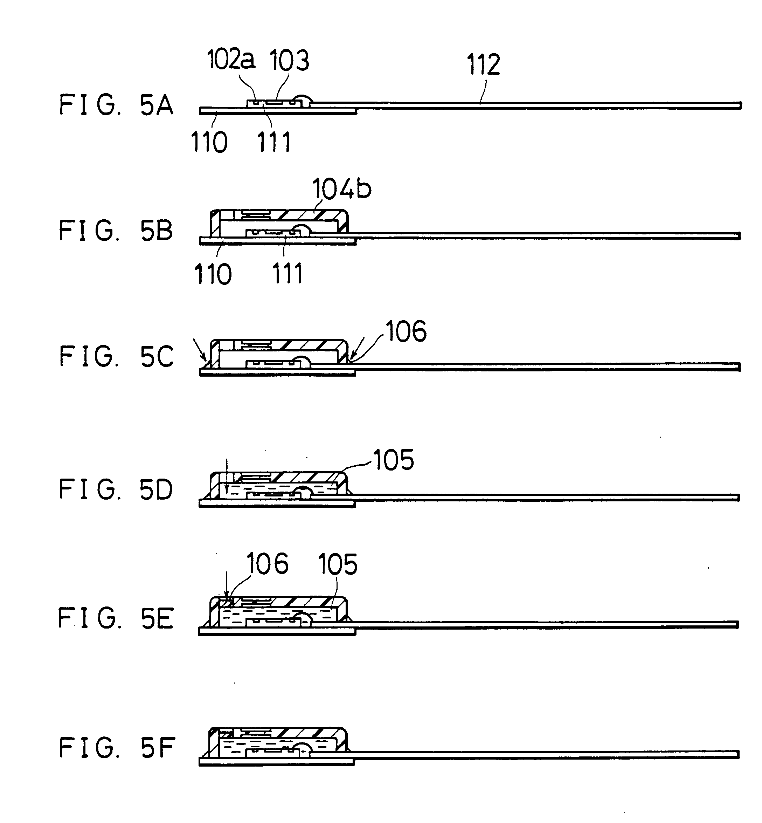

Figs. 5A-5F are views showing manufacturing steps of the semiconductor laser device of Fig. 3A;

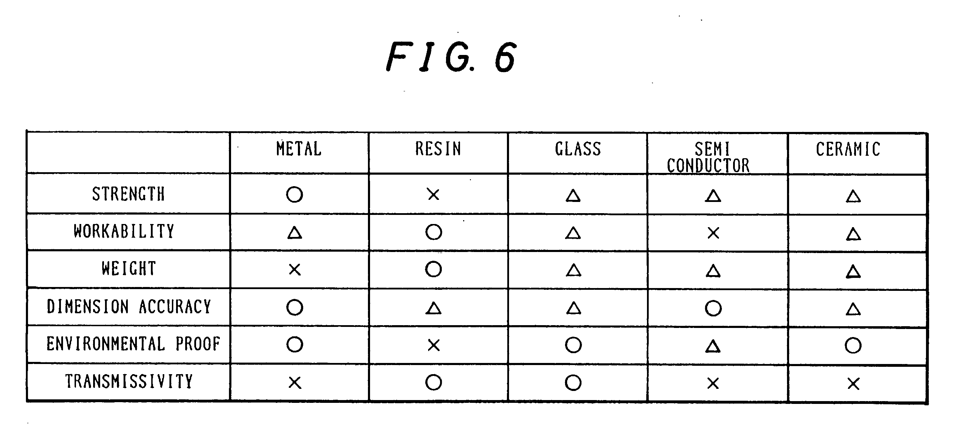

Fig. 6 shows features of materials;

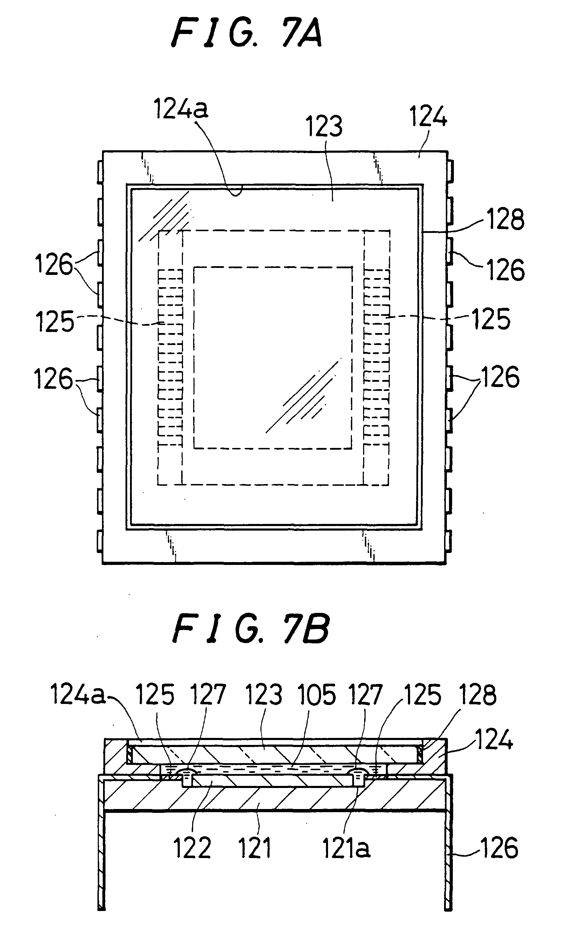

Figs. 7A, 7B are views of a fourth comparative example, particularly Fig. 7A is a cross sectional view and Fig. 7B a longitudinal sectional view thereof;

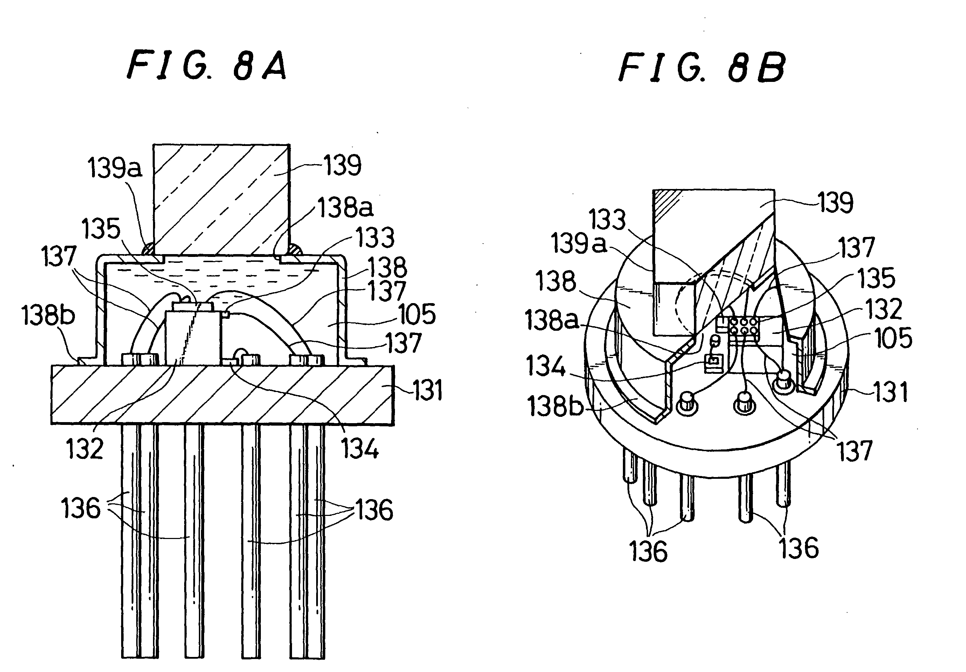

Figs. 8A, 8B are views of a semiconductor laser device used for an optical pickup for an optical disk as a first embodiment of the invention, particularly Fig. 8A a sectional view and Fig. 8B a partially cutaway view in perspective thereof;

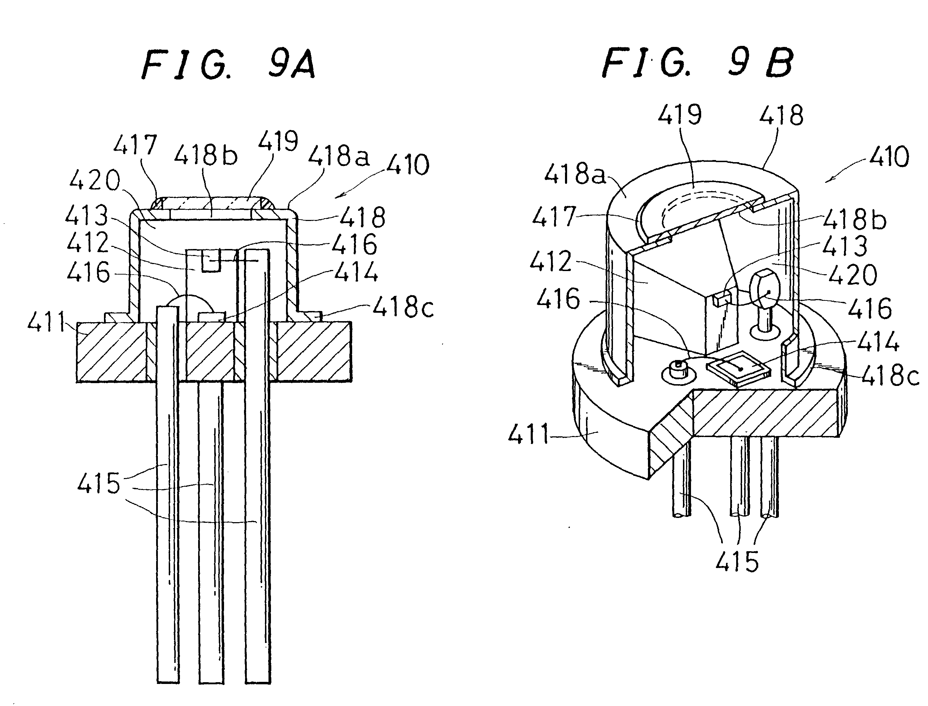

Figs. 9A, 9B are views of an integrated-type device used for an optical pickup for an optical disk of an second embodiment of the invention, particularly Fig. 9A a sectional view and Fig. 9B a partially cutaway view in perspective thereof;
Fig. 10 is a perspective view of a conventional semiconductor laser device;
Figs. 11A, 11B are constitutional views of a conventional device, particularly Fig. 11A a cross sectional view and Fig. 11B a longitudinal sectional view thereof;
Fig. 12 is a sectional view of another conventional device;
Fig. 13 is a sectional view of a conventional light emitting diode device;
Fig. 14 is a view for explaining the casting method for manufacturing the light emitting diode device of Fig. 13;

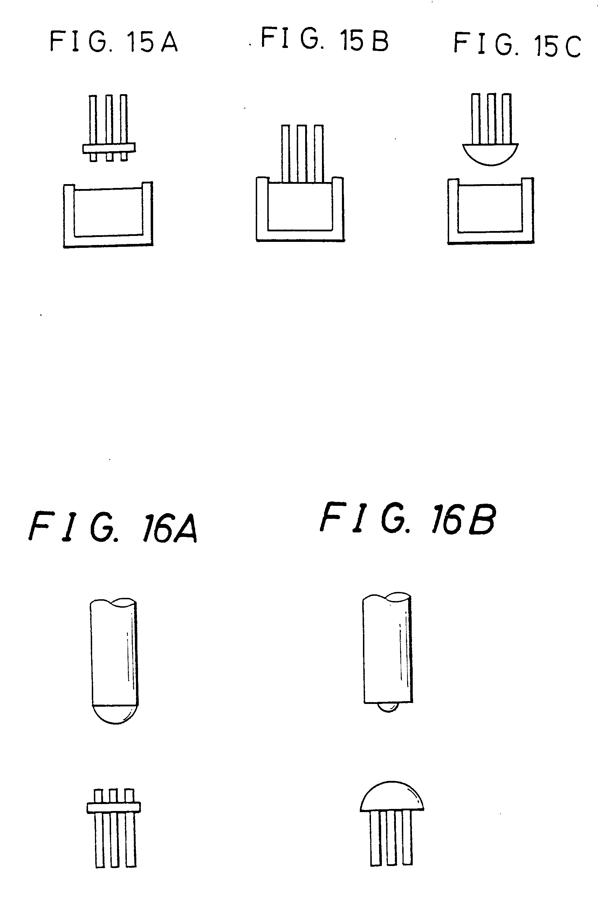

Figs. 15A-15C are views for explaining the dipping method therefor;
Figs. 16A, 16B are views for explaining the dropping method therefor;
Fig. 17 is a sectional view of other conventional light emitting diode device;
Figs. 18A-18I are views showing manufacturing steps of the light emitting diode device of Fig. 17A;
Figs. 19A, 19B are constitutional views of still other conventional light emitting diode device, particularly Fig. 19A a cross sectional view and Fig. 19B a longitudinal sectional view thereof;
Figs. 20A, 20B are constitutional views of a conventional solid imager device, particularly Fig. 20A a cross sectional view and Fig. 20B a longitudinal sectional view thereof;
Fig. 21 is a sectional view of a conventional semiconductor laser device used for a pickup for a laser disk of;
Figs. 22A, 22B are constitutional views of a conventional integrated-type device used for an optical pickup for an optical disk, particularly Fig. 22A a perspective view and Fig. 22B a sectional view thereof; and
Fig. 23 is a sectional view of other conventional integrated-type device used for an optical pickup for an optical disk.

### DETAILED DESCRIPTION OF THE PREFERRED EMBODIMENT

Now referring to the drawings, preferred embodiments of the invention are described below.

Figs. 1A, 1B are views showing a first comparative semiconductor laser device of the invention, particularly Fig. 1A a cross sectional view and Fig. 1B a longitudinal sectional view thereof.

As shown in Figs. 1A, 1B, the semiconductor laser device comprises a semiconductor laser element (chip) 102 mounted on a mounting portion 101a of a lead frame 101, a light receiving element 103 for detecting an optical output from the semiconductor laser element 102, a resin cap 104 with one end opened, mounted so as to cover both the elements 102, 103, a liquid material 105 filled into the resin cap 104, and a sealing resin 106 for sealing the liquid material 105 in order to prevent the liquid material from flowing out.

The lead frame is made of a metal such as copper and aluminum, and three lead frames are arranged in parallel with each other, the semiconductor laser element 102 is mounted at the tip portion of the lead frame in the middle of the three and the light receiving element 103 is mounted at a portion of the lead frame, bent at an angle of about 90° upwardly from the main body of the lead frame. The semiconductor laser element 102 and the light receiving element 103 are electrically connected through a bonding wire 107 to the different lead frames. Upwardly bending processing is carried out at the root portion of the mounting portion 101a.

The semiconductor laser element 102 is composed of a laser diode or the like, and the light receiving element 103 is composed of a photodiode for monitoring.

The resin cap 104, which is a laser-beam transmitting cap, is formed by injection molding or injection-compression molding of a thermoplastic resin such as acrylic resins and carbonates or by casting or the like of a thermosetting resin such as epoxy resins or the like. At the end of the resin cap 104, from which a laser beam outgoes, is formed an optical element 108 composed of a double aspheric surface lens or the like.

The fluid material 105 is a laser beam transmitting liquid resin such as a thermosetting resin and an ultraviolet setting resin.

The fluid material 105 is required to be thermal-, cold-, and weather- resistant, low gas permeable, and low moisture permeable, and a good electrical insulator. For that purpose, a silicone resin is used as the fluid material 105, which makes a success of attaining the same levels of environment resistance, lifetime, and wavefront aberration as those of semiconductor laser devices presently mass-produced. Alternatively, the requirements to be met only by the fluid material may be partially charged to the resin cap 104 and the sealing resin 106. For example, if the respective entire circumferences of the resin cap 104 and the sealing resin 106 are coated with fluorine, the requirements for the materials to be used for inner sides from the fluorine coating may be mitigated.

The sealing resin 106, which includes epoxy and silicone resins, seals the fluid material and fixes the lead.

In the semiconductor laser device of the example, since the fluid material 105 is filled in the resin cap 104, and the semiconductor laser element 102 is immersed in the fluid material 105, the semiconductor laser element 102 is prevented from contacting with the outside air. The heat from the heated semiconductor laser element is effectively released by convection as well as heat conduction and radiation of the fluid material 105. Accordingly, the space for releasing the heat from the heated semiconductor laser element can be reduced with a result of attainment of size reduction of the semiconductor laser device as a whole.

Additionally, the temperatures and the refractive indexes of the fluid material 105 in the resin cap 104 are spatially uniformed owing to convection of the fluid material 105, so that it is avoided that the wavefront aberration of the laser beam emitted from the semiconductor layer device is adversely changed.

Still further, since the thermal stress caused in the fluid material is equally distributed without partially concentrating because of the fluidity of the fluid material, the semiconductor laser element is prevented from being pressurized and from being adversely affected in lifetime.

The viscosity of the fluid material 105 is about 1000 times that of nitrogen or the like, the liquid resin can be prevented from leaking, even without sealing the gap between the resin cap 104 and the lead frames 101 like sealing a gas.

Incidentally, as the fluid material any liquid may be used besides mineral oils and silicone oil, as long as its own insulation level and light transmissivity are high and viscosity is 350CP/25°C or less.

Figs. 2A, 2B are constitutional views of a second comparative laser device, particularly Fig. 2A a cross sectional view and Fig. 2B a longitudinal sectional view thereof. Now, only differences of this comparative laser device from the comparative example will be described.

As shown in Figs. 2A, 2B, the laser device is constituted by a silicon substrate 109 mounted on the mounting portion 101a, the semiconductor laser element 102 mounted on the silicon substrate 109, and the light receiving element 103 formed in the silicon substrate 109. Additionally, the optical element at the end of the resin cap 104a in the laser beam outgoing direction is the optical element 108a formed in plane such as a plate, a diffraction grating and a hologram.

In the device, although an electrical connection terminal is taken out from the semiconductor laser device through the lead frames 102, the silicon substrate 109 may be used as the electrical connection terminal by elongating the silicon substrate 109 in the longitudinal direction to the outside of the sealing portion. Instead of the lead frames 101, a flexible printed cord (FPC) and a printed wiring board (PWB) may be used.

Figs. 3A-3C are constitutional views of a third comparative example, particularly Fig. 3A a plan view, Fig. 3B a cross sectional view and Fig. 3C a longitudinal sectional view thereof.

As shown in Figs. 3A, 3B, the semiconductor laser device of the example is constituted by a radiation plate 110, made of a metal such as copper and/or aluminum, a ceramic, silicon or the like, a compound semiconductor substrate 111 mounted in the middle portion of the radiation plate 110, in which a surface emission semiconductor laser element 102a and the light receiving element 103 for detecting the optical output of the semiconductor laser element are formed, and a flexible printed cord (FPC) 112 mounted at the end of the radiation plate. The surface emission semiconductor laser element 102a and the light receiving element 103 are electrically connected to the FPC 112 via a bonding wire.

The compound semiconductor substrate 111 is airtight closed by adapting a resin cap 104b with an opening to the radiation plate 110, and a hole for injecting the fluid material 105 is provided in the portion of the compound semiconductor substrate 111, confronting the opening portion. After injection of the fluid material 105, the hole is sealed with the sealing resin 106.

The same as the foregoing example, a laser beam transmitting liquid resin such as a silicone resin is used as the fluid material 105, and as the resin cap 104b is used a laser beam transmitting resin cap formed by injection molding or injection-compression molding of a thermoplastic resin such as an acrylic resin and a carbonate or by casting or the like of a thermosetting resin such as an epoxy resin.

At the end of the resin cap 104, from which a laser beam outgoes, is formed an optical element 108b such as a flat plate, a diffraction grating, and a hologram. The sealing resin 106, which includes epoxy resins and silicone resins, seals the fluid material 105 and fixes the FPC 112.

In the example, although an electrical connection terminal is taken out from the semiconductor laser device through the FPC 112, the compound semiconductor substrate 111 may be used as the electrical connection terminal by elongating in the longitudinal direction to the outside of the sealing portion. Instead of the FPC 112, a lead frame and a printed wiring board (PWB) may be used.
Alternatively, the compound semiconductor substrate 111 may be used as a radiation plate to eliminate the radiation plate 110.

Also in the example the same operation and effect are attained as that of the foregoing example.

In the following, methods for manufacturing the above-mentioned semiconductor laser devices are described.

Fig. 4 is a view showing manufacturing steps of the semiconductor laser device of Fig. 1.

As shown in Fig. 4A, firstly the resin cap 104 is arranged. Secondly, as shown in Fig. 4B, the lead frame 101 in which the semiconductor laser element 102 and the light receiving element 103 are mounted is arranged in the resin cap 104. Next, as shown in Fig. 4C, the resin cap 104 is filled with the fluid material 105 by the use of a dispenser (not shown). Subsequently, as shown in Fig. 4D, an electric current is sent via the lead frame 101 into the semiconductor laser element 102, whereby the semiconductor element begins to oscillate. Then the position and angle of the semiconductor laser element 102 are adjusted in relation to the optical element 108, while observing the laser beam. Subsequently, as shown in Fig. 4E, the surface of the fluid material 105 is covered with the sealing resin 106 to be set, by lowering the specific gravity of the sealing resin 106 to a lower level than that of the fluid material 105 or elevating the viscosity of the sealing material 106. The device as shown in Fig. 4F is a finished product.

Additionally, the step of arranging the lead frame 101 into the resin cap 104 as shown in Fig. 4B and the step of filling the resin cap 104 with the fluid material 105 as shown in Fig. 4C are changeable for each other. The adjustment of laser beam as shown in Fig. 4D can be omitted, if the automatic positioning machine for positioning the lead frame 101 and the resin cap 104 has a high precision.

The manufacturing steps of the semiconductor laser device as shown in Fig. 2A are the same as those of the semiconductor device as shown in Fig. 1A. Therefore, only the differences between the manufacturing steps thereof will be described.

In the semiconductor laser device of Fig. 2A, since the optical element 108a of the resin cap 104a is formed in plane, what is to be carried out at the step of Fig. 4D is only the angular adjustment of the semiconductor laser element 102.

Figs. 5A-5F are views showing manufacturing steps of the semiconductor laser device of Fig. 3A.

As shown in Fig. 5A, firstly a compound semiconductor substrate 111 in which the surface emission laser element 102a and the light receiving element 103 are formed, and the heat radiation plate 110 to which a FPC 112 is mounted are arranged. Secondly, as shown in Fig. 5B, the resin cap 104b is arranged on the heat radiation plate so as to cover the compound semiconductor substrate 111. Subsequently, as shown in Fig. 5D, the fluid material 105 is filled through a hole provided on the top face of the resin cap 104b into the resin cap 104b as indicated with an arrow. Next, as shown in Fig. 5E, the hole provided on the top face of the resin cap 104b is covered with the sealing material 106 having a specific gravity less than that of the fluid material 105 or a viscosity higher than that of the fluid material 105 in order to be sealed with the cured sealing material 106. The device as shown in Fig. 5F is a finished product.

As partially described in the above examples, the materials of the cap and the substrate may include metals, resins, glasses, semiconductors, and ceramics. Since there are as much as 25 combinations of such materials, only the features are shown in Fig. 6 for the purpose of simplification. In accordance with the requirements for the device, the materials are selected each time. In Fig. 6, the characteristics of the materials are indicated in three grades with marks, ○, Δ, X, and ○ indicates the best.

The above, which are embodiments of semiconductor laser devices, are also applicable to light emitting diode devices when a light emitting diode element is mounted instead of the semiconductor laser device, and the light receiving element, which is unnecessary to a light emitting diode device, is eliminated.

Figs. 7A, 7B are views of a further comparative example, particularly Fig. 7A is a cross sectional view and Fig. 7B a longitudinal sectional view thereof.

The solid imager device comprises an alumina substrate 121 which has a concavity 121a formed in the middle of the top face thereof and is metallized, a solid imager element (CCD chip) 122 arranged in the concave 121a of the alumina substrate 121, a glass plate 123 covering the CCD chip 122, and an alumina cap 124 supporting the glass plate 123.

The CCD chip 122 is mounted and bonded to the alumina substrate 121. Metallized electrodes 125 are provided on the surfaces of both sides of the concave 121a and are electrically connected to a terminal 126 arranged along the top face and respective sides of the alumina substrate 121. The metallized electrode 125 is electrically connected to the CCD chip 122 via a bonding wire 127.

The alumina cap 124 having an opening 124a in the middle portion thereof is arranged on the alumina substrate 121. The opening 124a of the alumina cap 124 is wider than the concave 121a of the alumina substrate 121 and the flat glass plate 123 is arranged in the opening 124a. The flat glass plate 123 is supported at a certain interval from the surface of the CCD chip 122 and covers the entire surface of the CCD chip 122 and the metallized electrode 125 arranged on the alumina substrate 121. The side face of the glass plate 123 is bonded and fixed to the inner circumferential surface of the opening 124a with an ultraviolet setting resin 128.

The region below the glass plate 123 in the opening 124a of the alumina cap 124, and the concave 121a of the alumina substrate 121 are filled with the fluid material 105. The same as the foregoing examples, the fluid material 105 includes fluid resins such as silicone resins, silicone oil, fluoro inert liquids and mineral oils, having a transmissivity such that the light to be received by the CCD chip is transmitted and the CCD chip 122 arranged in the concave 121a of the alumina substrate 121 and metallized electrode 125 are immersed in the fluid material 105.

A solid imager device with such constitution is fabricated in the following manner. The solid imager chip (CCD chip ) 122 is arranged in the concave 121a of the metallized alumina substrate 121 (ceramic base) and fixed thereto with an adhesive material and the CCD chip 122 and the metallized electrode 125 are electrically connected to each other via the bonding wire 127a. Thereafter the alumina cap 124 which is in a state that the glass plate 123 is not supported is bonded in the opening 124a with a low melting point glass or the like to the alumina substrate 121. In such state, the fluid material 105 is filled by a dispenser or the like through the opening 124a of the alumina cap 124 and the glass plate 123 is bonded in the opening 124a.

In the solid imager device, the light transmitted through the glass plate 123 is transmitted through the fluid material 105 and received by the CCD chip 122.

The solid imager device of the embodiment is also prevented from being aversely affected by the outside air because the CCD chip is protected by the fluid material 105.

Though herein the solid imager device such as a CCD chip is given as an example for description, similar ceramic sealing is also applicable to other light-emitting elements.

Also in the solid imager device shown in Figs. 7A, 7B, the same as the mentioned-above semiconductor laser device, the materials of the cap and substrate are selected each time, depending on the requirements for the device. Since the manufacturing method is similar to that of the semiconductor laser device, the description thereof is eliminated herein.

Figs. 8A, 8B are views of a semiconductor laser device used for an optical pickup for an optical disk as a first embodiment of the invention, particularly Fig. 8A a sectional view and Fig. 8B a partially cutaway view in perspective thereof. In the semiconductor laser device, a heat sink 132 as one body with the stem is provided on a disk-type metal stem 131. A semiconductor laser element 133 is mounted on the side face of the heat sink 132 so that the laser emitting face thereof is directed upwardly. A laser beam upwardly emitted from the semiconductor laser element 133 is applied on an optical disk (not shown).

A photodiode 134 for monitoring is mounted at the position where a laser beam downwardly emitted from the semiconductor laser element 133 can be received. A photodiode 135 for detecting a signal is mounted at the position where the laser beam emitted from the semiconductor laser element 133 and reflected on the optical disk can be received.

The stem 131 is provided with a plurality of terminals 136, the end of each terminal which penetrates through the stem 131 and reaches the top face of the stem is electrically connected to the semiconductor laser element 133, photodiode 134 for monitoring, and photodiode for detecting a signal 135 via the bonding wire 137.

The heat sink 132 and photodiode 134 on the stem 131, the end of each terminal 136 penetrating through the stem 131, and the semiconductor laser device 133 are covered with a cap 138. The cap 138 is cylindrical with a bottom opened and a top face having an opening 138a. The opening in the top face is round-shaped, and is closed with a rectangular parallelopiped hologram glass 139 mounted to the top face of the cap 138. The circumference of the hologram glass 139 is bonded to the top face of the cap 138 with an adhesive material 139a such as an ultraviolet setting resin, which seals the space between the top face of the cap and the circumference of the hologram glass 139.

At the lower end of the cap 138 is provided a flange 138b outwardly extending in a horizontal direction, which is bonded on the stem 131 with an adhesive material such as an ultraviolet setting resin or by spot welding. For example, when the cap 138 is made of metal, the flange is bonded on the stem 131 with an ultraviolet setting resin or by spot welding, or when the cap 138 is made of resin, the flange is bonded on the stem 131 by an ultraviolet setting resin.

The cap 138 is filled with the transparent fluid material 105. The fluid material 105 includes liquid resins such as silicone resins, having a transmissivity such that a laser beam is transmitted therethrough, the same as the foregoing embodiment, and the photodiode 134 for monitoring on the stem 131, the end of each terminal 136, the heat sink 132, the semiconductor laser element 133, and the photodiode 135 for detecting a signal are immersed in the fluid material 105.

In such a semiconductor laser device, the laser beam from the semiconductor laser element 133 passes through the fluid material 105 and the hologram glass plate 139 and is applied to an optical disk. The laser beam from the semiconductor laser element 133 is applied also to the photodiode 134 for monitoring arranged on the stem 131 and on the basis of the results of detection by the photodiode 134 for monitoring, the output of the laser beam from the semiconductor laser element 133 is regulated.

The laser beam reflected on the optical disk is applied to the photodiode 135 for detecting a signal arranged on the heat sink 132, and on the basis of the results of detection by the photodiode for detecting a signal, the information written in the optical disk is read out.

A semiconductor laser device with such constitution is fabricated in the following manner. The semiconductor laser element 133 etc. are mounted on the stem 131, and bonded via a wire bonding, and thereafter the cap 138 is installed to the stem 131. Next the fluid material 105 is filled through the opening 138a provided on the top face of the cap 138 and finally the hologram glass 139 is installed on the top face of the cap 138.

In the embodiment, the flat glass 46 of the cap 47 employed in the prior art may be eliminated because the hologram glass 139 may be substituted therefor. There is a difference between the viscosities of nitrogen, which is employed in the prior art, and the fluid material used in the embodiment, and accordingly encapsulation of the fluid material is completely achieved by the hologram glass 139.

Additionally, when the refractive index of the fluid material 105 is made equal to that of the hologram glass, the laser beam is not reflected at the boundary between the fluid material 105 and the hologram glass 139 and accordingly the laser beam reflected from the optical disk can be effectively applied to the photodiode 135 for detecting a signal as well as the laser beam from the semiconductor laser element 133 can be effectively applied to the optical disk. Thus the laser beam availability is enhanced.

Figs. 9A, 9B are views of an integrated-type device used for an optical pickup for an optical disk of a further embodiment of the invention, particularly Fig. 9A sectional view and Fig. 9B a partially cutaway view in perspective thereof. The semiconductor laser device 410 comprises a disk-type metal stem 411, a heat sink 412 as one body with the stem 411, provided on the disk-type metal stem 411, a semiconductor laser element 413 mounted on the side face of the heat sink 412, and a photodiode 414 for monitoring mounted on the stem 411.

The semiconductor laser element 413 is mounted on the side of the heat sink 412 in a state that an appropriate space is left on the stem 411. The face from which a laser beam is emitted is directed upwardly. The photodiode 414 mounted to the stem 411 can receive a laser beam upwardly emitted from the semiconductor laser element 413.

The stem 411 is provided with a plurality of terminals 415 so that each terminal penetrates through the stem 411. Two terminals 415 are electrically connected to the semiconductor laser element 413 and photodiode 414 via bonding wires 416, respectively.

The heat sink 412 and photodiode 414 on the stem 411, the end of each terminal 415 penetrating through the stem 411, and the semiconductor laser device 413 mounted on the side face of the heat sink 412 are covered with a cap 418. The cap 418 is cylindrical with a bottom opened and a top face 418a having an opening 418b. The opening provided in the middle portion of the top face 418a is round-shaped, and is closed with a disk-shaped light transmitting glass plate 419. The circumference of the glass plate 419 is bonded to the top face 418a of the cap 418 with an adhesive material 417 such as an ultraviolet setting resin, which seals the space between the top face 418a of the cap and the circumference of the glass plate 419.

At the lower end of the cap 418 is provided a flange 418c outwardly extending in a horizontal direction, which is bonded on the stem 411 with an adhesive material such as an ultraviolet setting resin or by spot welding.

The cap 418 is filled with the transparent fluid material 420. The fluid material 420 has a transmissivity such that a laser beam is transmitted therethrough, and the photodiode 414 on the stem 411, the end of each terminal 415, the heat sink 412, and the semiconductor laser element 413 are immersed in the fluid material 420.

As the fluid material 420 are used silicone oils, fluoro inert liquids, mineral oils, etc. which protect the semiconductor laser element 413 from the outside air, have a heat radiation function, and are superior in heat resistance, cold resistance, weather resistance and electrical insulating property, and inferior in gas and moisture permeability. In particular, silicone oils and fluoro inert liquids have better properties than mineral oils. As the fluid material 420 is used, for example, the silicone oil under the trade name of OF-37A (viscosity: 0.3PaS/25°C) made by Shin-Etsu Chemical Co., Ltd.

A semiconductor laser device with such constitution is fabricated in the following manner. The semiconductor laser element 413 is mounted on the side face of the heat sink 412 which is formed as one body with the stem. The photodiode 414 is mounted on the stem 411, and each terminal attached to the stem 411, the photodiode 414, and the semiconductor laser element 413 are electrically connected to each other via bonding wires 416. Thereafter the cap 418 with an opening 418b in an open state is put on the stem 411, and the flange 418c of the cap 418 is bonded to the stem 411 with an adhesive material such as ultraviolet setting resins or by spot welding.

In such state, the fluid material 420 is filled by a dispenser or the like through the opening 418b provided on the top face 418a of the cap 418. Thereafter the opening 418b is closed by the disk-type glass plate 419 and the circumference of the glass plate is bonded with the opening 418b with an adhesive material 417 such as ultraviolet setting resins. In such manner, the semiconductor laser device shown in Figs. 9A, 9B is fabricated.

In such a semiconductor laser device 410, the laser beam from the semiconductor laser element 413 is transmitted through the fluid material 420 and glass plate 419 to the outside. The laser beam from the semiconductor laser element 413 is applied to the photodiode 414 and on the basis of the results of detection by the photodiode 414, the output of the laser beam from the semiconductor laser element 413 is regulated.

The invention may be embodied in other specific forms without departing from the essential characteristics thereof. The present embodiments are therefore to be considered in all respects as illustrative and not restrictive, the scope of the invention being indicated by the appended claims rather than by the foregoing description and all changes which come within the meaning of the claims are therefore intended to be embraced therein.

## Claims

1. A method of manufacturing a semiconductor device of the type incorporating a sealing liquid, the method comprising:
arranging a semiconductor element on a substrate;
mounting a cap (104, 104b) on the substrate so as to cover the semiconductor element; and
introducing a liquid material (105, 304) for sealing into the cap through an opening (138a) provided in the cap or the substrate;
the method being **characterised in that** it further comprises the step of closing the opening (138a) with an optical element (139) after the step of introducing the liquid material (105, 304) into the cap (104, 104b); and **in that** the semiconductor element is a light-emitting element.

2. A method of manufacturing a device as claimed in claim 1, wherein the semiconductor element is a semiconductor laser element (102, 102a).

3. A method of manufacturing a device as claimed in claim 1, wherein the liquid material is composed of a liquid resin.

## Patentansprüche

1. Verfahren zum Herstellen eines Halbleiterbauteils vom Typ mit einer Abdichtungsflüssigkeit, das Folgendes umfasst:
- Anordnen eines Halbleiterelements auf einem Substrat;
- Anbringen einer Abdeckung (104, 104b) auf dem Substrat, um das Halbleiterelement abzudecken; und
- Einfüllen eines flüssigen Materials (105, 304) zur Abdichtung in die Abdeckung durch eine in dieser oder im Substrat vorhandene Öffnung (138a) hindurch;
**dadurch gekennzeichnet, dass** dieses Verfahren ferner den Schritt des Verschließens der Öffnung (138a) mit einem optischen Element (139) nach dem Schritt des Einfüllens des flüssigen Materials (105, 304) in die Abdeckung (104, 104b) aufweist, und dass das Halbleiterelement ein Licht emittierendes Element ist.

2. Verfahren zum Herstellen eines Bauteils nach Anspruch 1, bei dem das Halbleiterelement ein Halbleiterlaserelement (102, 102a) ist.

3. Verfahren zum Herstellen eines Bauteils nach Anspruch 1, bei dem das flüssige Material aus einem flüssigen Harz besteht.

## Revendications

1. Procédé de fabrication d'un composant à semiconducteur du type incorporant un liquide d'étanchéité, le procédé comprenant :
l'agencement d'un élément à semiconducteur sur un substrat ;
le montage d'un capuchon (104, 104b) sur le substrat de façon à recouvrir l'élément à semiconducteur ; et
l'introduction d'une matière liquide (105, 304) pour l'étanchéité dans le capuchon à travers une ouverture (138a) réalisée dans le capuchon ou le substrat ;
le procédé étant **caractérisé en ce qu'**il comprend en outre l'étape de fermeture de l'ouverture (138a) avec un élément optique (139) après l'étape d'introduction de la matière liquide (105, 304) dans le capuchon (104, 104b) ; et **en ce que** l'élément à semiconducteur est un élément luminescent.

2. Procédé de fabrication d'un composant selon la revendication 1, dans lequel l'élément à semiconducteur est un élément de laser à semiconducteur (102, 102a).

3. Procédé de fabrication d'un composant selon la revendication 1, dans lequel la matière liquide est composée d'une résine liquide.
